Europäisches Patentamt

European Patent Office

Office européen des brevets

(11) Publication number: **0 520 678 A2**

# EUROPEAN PATENT APPLICATION

(21) Application number: **92305565.1**

(22) Date of filing: **17.06.92**

(51) Int. Cl.5: **H03L 7/08**, H03L 7/12

(30) Priority: **25.06.91 GB 9113682**

(43) Date of publication of application:
**30.12.92 Bulletin 92/53**

(84) Designated Contracting States:
**DE ES FR**

(71) Applicant: **FERRANTI INTERNATIONAL plc**
**Bridge House Park Road Gatley**
**Cheadle Cheshire SK8 4HZ(GB)**

(72) Inventor: **Hardstone, Julian**
**17 Whitefield, Heaton Norris**
**Stockport, Cheshire SK4 2PE(GB)**
Inventor: **Wilson, Martin Paul**
**c/o Sunnyvale, Beck Lane, Welton-le-Marsh**
**Spilsby, Lincolnshire(GB)**
Inventor: **Lee, Brian Shepherd**
**44 Oueen's Road, Cheadle Hulme**
**Stockport, Cheshire SK8 5LU(GB)**

(54) **Image-rejecting phase detector.**

(57) A fixed-frequency oscillator (12) provides a signal to a phase-shifting network (22) which provides two signals of the same fixed frequency but in phase quadrature. Two mixers (20, 21) are provided, to each of which is applied an output from a voltage-controlled oscillator (10) and a separate one of the two phase quadrature signals. A phase detector (13) responds to the outputs of the mixers (20, 21) and to a reference signal from a further oscillator (14) to provide an output voltage for application to the voltage-controlled oscillator (10) to control the frequency thereof.

FIG.2

EP 0 520 678 A2

Phase detector circuits are used in situations where the phase relationship between two signals is required to produce a voltage output dependent upon that relationship. One particular application is that of the phase-locked loop where the frequency of a voltage-controlled oscillator is controlled by effecting a phase comparison between its output and that of a high-stability reference oscillator. The voltage output of the phase detector is used to control the output frequency of the voltage-controlled oscillator.

Frequently, to allow the phase detector to operate at a frequency lower than that of the voltage-controlled oscillator, the phase-locked loop includes a mixer to which are applied both the output of the voltage controlled oscillator and a signal from a second reference source. The mixer output is a combination of two signals, one at a frequency equal to the second reference oscillator frequency plus the frequency of the voltage-controlled oscillator and the other at a frequency equal to the second reference oscillator frequency minus the frequency of the voltage-controlled oscillator. One of these will be equal to the reference frequency when the voltage-controlled oscillator is correctly tuned, whilst the other is greatly different and may be removed by filters. However, two different frequencies from the voltage-controlled oscillator will give rise to a frequency equal to the reference frequency and only one of these will be the desired output frequency. This situation may arise when the frequency of both the voltage-controlled oscillator and the second reference oscillator are much greater than that of the high-stability reference oscillator. Clearly the ambiguity which arises will have to be resolved if both of the possible signal frequencies from the voltage-controlled oscillator lie within the tuning range of that oscillator.

Conventional phase detector circuits are unable to resolve this ambiguity and it is an object of the invention to provide a phase detector which will allow such a selection to be carried out. The technique used is known as "image-rejection".

According to the present invention there is provided a phase-locked loop oscillator control circuit which include a voltage-controlled oscillator, a fixed frequency oscillator, a phase-shifting network to which the output of the fixed frequency oscillator is applied and operable to derive two signals at the same fixed frequency but in phase quadrature with one another, two mixer circuits to each of which are applied the output of the voltage-controlled oscillator and a separate one of the quadrature signals, and a phase detector responsive to the outputs of the two mixer circuits and to a reference signal to provide a voltage output for application to the voltage-controlled oscillator to control the output frequency thereof.

The invention will now be described with reference to the accompanying drawings, in which:-

Figure 1 is a schematic diagram of a conventional phase-locked loop;

Figure 2 is a schematic diagram of a phase-locked loop according to the invention;

Figure 3 is a diagram of the phase detector according to a first embodiment of the invention;

Figure 4 is a diagram of the phase detector according to a second embodiment of the invention; and

Figure 5 is a block diagram of an application of the invention.

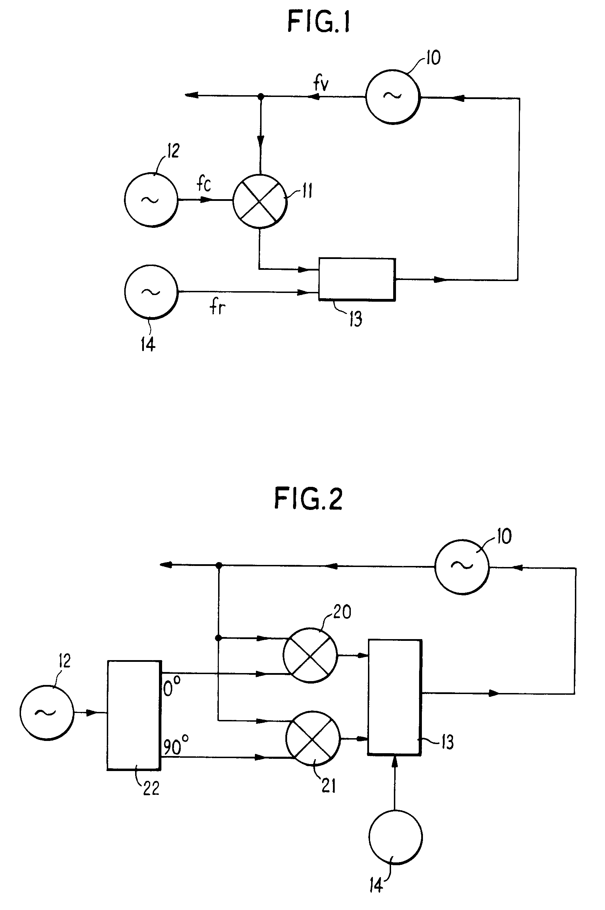

Referring now to Figure 1, this shows a conventional phase-locked loop in which a voltage-controlled oscillator 10 is required to produce an output signal at a frequency fv within its tuning range. The output signal is applied to a mixer 11 to which is also supplied a signal at a frequency fc from a crystal oscillator 12. The output of the mixer is applied to a phase detector 13 to which is also applied a reference signal at a frequency fr from a highly accurate and stable oscillator 14. The output of the phase detector 13 is a voltage which controls the tuning of the voltage-controlled oscillator 10 and hence its output frequency.

By way of example only, consider the situation where the voltage-controlled oscillator 10 is tunable over a frequency range from 9 to 11MHz. Suppose also that the frequency fc supplied by the crystal oscillator 12 is 10MHz and the reference frequency fr from the high-stability oscillator 14 is 50KHz. The output of the phase detector 13 will lock the frequency of the voltage-controlled oscillator 10 at a frequency which produces an output from the mixer 11 at 50KHz. This will occur both when the oscillator frequency is 10.05MHz and when it is 9.95MHz. It is this ambiguity which presents the problem, since the two possible output frequencies of the voltage-controlled oscillator are within its tuning band and the phase detector 13 is unable to distinguish between them.

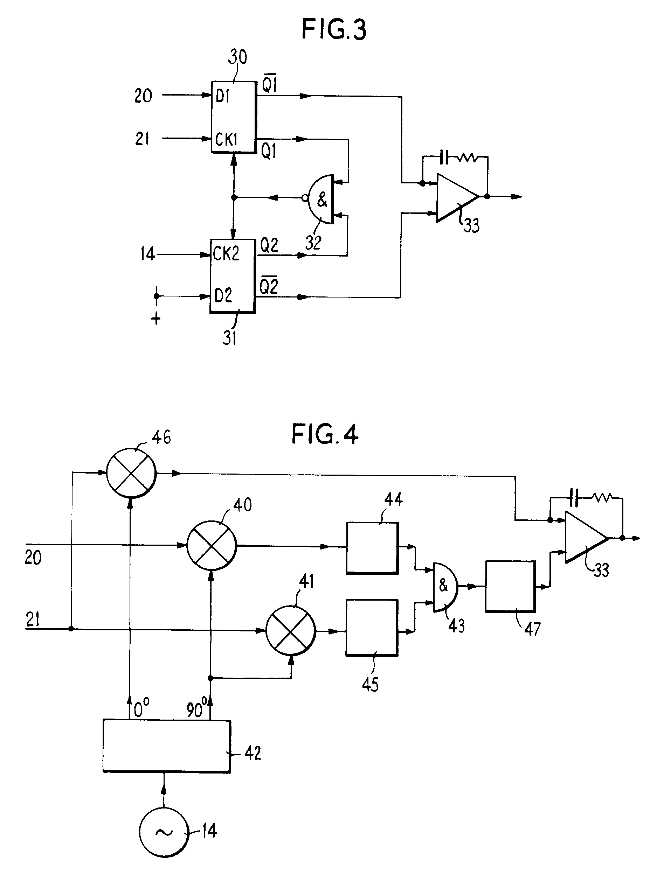

Figure 2 is a similar drawing of a phase-locked loop but this time including a phase detector according to the inventions and the same references have been used where appropriate. It will be seen that the main difference is that in place of the single mixer 11 show in Figure 1, two mixers 20 and 21 are provided and the fixed frequency oscillator 12 applies a signal to a phase-shifting network 22 which supplies phase-quadrature signals to the two mixers. The phase detector circuit 13 receives the outputs of the two mixers and also the reference signal from the reference oscillator 14. The phase detector is able to detect the different phase relationship between the reference signal and the mixer outputs which occurs when the mixer input is one of the two possible oscillator output frequencies and when the mixer input is the other of the two frequencies. The image-rejecting phase detector which carries out this function may be produced in either analogue or digital forms, and one example of each will be described. Figure 3 shows a digital version in block diagram form.

Basically, the phase-detector comprises two D-type bistable circuits 30 and 31 and a NAND gate 32. Each bistable circuit has "data" (D), "clock" (CK) and "reset" (R) inputs and two outputs, denoted Q and $\overline{Q}$. The data (D1) and clock (CK1) inputs of bistable 30 are connected to the outputs of mixers 11 and 11' respectively (Figure 2). The other bistable circuit has its data input D2 connected to a fixed voltage representing a '1' state and its clock input CK2 connected to the reference frequency signal from reference oscillator 14. In the example shown the two Q outputs, Q1 and Q2, form the inputs to NAND gate 32, the output of which is connected to the reset (R) input of each bistable circuit. The $\overline{Q}$ outputs, $\overline{Q}$1 and $\overline{Q}$2 form the inputs of loop amplifier and integrator 33. It is this which develops the control voltage which controls the output frequency of voltage-controlled oscillator 10.

Since the circuit shown is a digital circuit it is necessary to ensure that the signals applied to it are square waves. Hence the outputs from the two mixers 20 and 21 need to be converted to square-wave form and the reference signal from oscillator 14 needs to be a square-wave signal.

When the phase of the signals applied to bistable circuit 30 is correct then the data inputs always goes 'high' before the clock input, providing a digital '1' at the Q1 output on the rising edge of the clock input pulse. Each bistable is reset by the outputs from gate 32 before the next inputs to bistable circuit 30. The two $\overline{Q}$ outputs of the bistable circuits 30 and 31 remain set at '0' apart from short-duration reset pulses and hence no output is produced from integrator 33 to change the frequency of the voltage-controlled oscillator.

When the phase relationship is incorrect, due to the voltage-controlled oscillator being wrong, then bistable circuit 30 changes state and the Q1 output becomes '0' and the $\overline{Q}$1 outputs becomes '1'. This results in an output from integrator 33 to change the frequency of the voltage-controlled oscillator 33 until the correct frequency is obtained.

Figure 4 shows an analogue version of the phase detector. Squaring circuits are not required and the reference signal should be a sinusoidal signal. Referring now to Figure 4, it will be seen that further mixers have been included. The outputs of the two mixers 20 and 21 are connected to two further mixers 40 and 41 respectively, these further mixers being supplied by way of a phase-shifting network 42 with quadrature signals at the reference frequency from reference source 14. The outputs of the two further mixers 40 and 41 are connected to an AND gate 43 through threshold detectors 44 and 45 to ensure that a positive output from the mixer corresponds to a logical HIGH and a negative output corresponds to a logical LOW.

The output of mixer 21 is also connected to a mixer 46 which is supplied with the reference frequency signal. The output of this mixer 46 is connected to one input of the integrating amplifier 33. A sweep generator 47 is connected to the other input of the amplifier 33 and is operable to cause the voltage from the amplifier to sweep the output of the voltage-controlled oscillator over its full frequency range. The output of AND gate 43 is connected to a "stop sweep" input of the sweep generator 47.

When the outputs of the two mixers 40 and 41 result from the correct phase relationship between the inputs to mixers 20 and 21 then the "stop sweep" signal is generated by gate 43 and no control voltage is produced by amplifier 33. However, if the phase relationship changes due to the voltage-controlled oscillator 10 providing an output of the wrong frequency then the frequency is changed to the correct value.

The phase detector circuits described above may be used for direct modulation of an oscillator output for radio communications applications. Modulation is performed simply by suitable variation of the frequency of the high-stability reference signal. It is possible to vary the frequency of the oscillator 14, as is probably necessary in the case of the analogue circuit of Figure 4. For the digital arrangement of Figure 3 the reference signal may be applied to a frequency changing circuit. The simplest form of modulation is frequency-shift keying, where two closely-related frequencies represent the mark and space states of a keying signal, transmitting simple binary data.

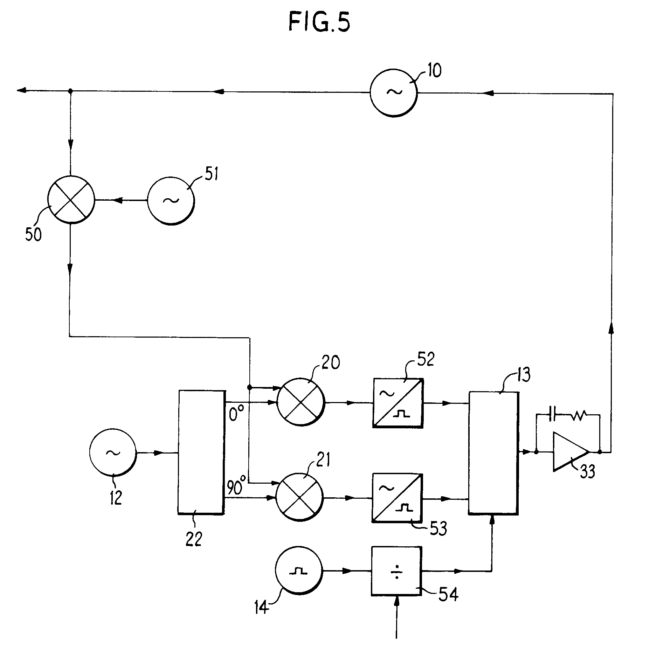

Figure 5 illustrates an application of such a keyed oscillator control, in this case for an emergency position-indicating beacon for use with the Inmarsat satellites. Because of the high frequency necessary for such an application a further mixer is used to produce an intermediate frequency. The circuit of Figure 5 uses digital techniques.

The voltage-controlled oscillator 10 produces an output signal at about 1644.3MHz which is applied to a mixer 50 along with a signal at 1640MHz from a stable oscillator 51. One output of the mixer, selected by the appropriate filters, is a signal at 4.3MHz, the intermediate frequency. This signal is the equivalent of the oscillator input to the mixer 20 and 21 of Figure 2. Oscillator 12 produces an output frequency of 4.33MHz so that the mixer outputs are signals at 30KHz. Because this is a digital circuit two squaring circuits 52 and 53 are provided as shown through which the mixer outputs are applied to the phase detector 13, which may be of the form shown in Figure 3.

The high-stability reference signal is produced by reference oscillator 14 at a frequency of 3.96MHz. This is applied to a dual modulus divider 54 which divides the reference frequency by either 128 or 129 depending upon the state of a keying signal input. Hence the reference signal is at either 30.6975KHz or at 30.9375KHz. The frequency shift between these is 240Hz, which is the desired shift frequency. Hence the application of binary data on the keying input to the dual-modulus divider 54 causes changes in the frequency of the voltage-controlled oscillator 10 by 240Hz.

It will be appreciated that changes may be made to the circuits described above without departing from the essential features of the invention. The main one of these features is the ability of the invention to overcome the problem of discriminating between two closely-spaced frequencies within the tuning range of a voltage-controlled oscillator.

## Claims

1. A phase-locked loop oscillator control circuit which includes a voltage-controlled oscillator (10), a fixed frequency oscillator (12), mixer means to which are applied the output of the voltage-controlled oscillator (10) and an output derived from the fixed frequency oscillator, and a phase detector (13) responsive to the output of the mixer means and to a reference signal to provide a voltage output for application to the voltage-controlled oscillator (10) to control the output frequency thereof, characterised by a phase-shifting network (22) to which the output of the fixed frequency oscillator (12) is applied and operable to derive two signals at the same fixed frequency but in phase quadrature with one another, the mixer means comprising two mixer circuits (20, 21) to each of which are applied the output of the voltage-controlled oscillator (10) and a separate one of the quadrature signals.

2. A circuit as claimed in Claim 1 characterised in that the phase detector (13) is operable to distinguish between the mixer outputs resulting from each of two closely-spaced but different output frequencies of the voltage-controlled oscillator (10) to ensure that only the required one of the two frequencies is generated.

3. A circuit as claimed in either of Claims 1 or 2 characterised in that the phase detector circuit (13) includes a pair of bistable circuits (30, 31) one of which has the two mixer outputs connected to its clock and data inputs respectively and the other of which has the reference signal connected to its clock input, one output of each bistable circuit being connected through a common gate (32) to the reset inputs of the two bistable circuits (30, 31) whilst the other output of each bistable circuit is connected to a common loop integrator amplifier (33) operable to derive the appropriate voltage-control signal.

4. A circuit as claimed in either of Claims 1 or 2 characterised in that the phase detector circuit (13) includes a further pair of mixer circuits (40, 41) connected to the outputs of the first mixer circuits (20, 21) and each supplied with one output from a further phase-shifting network (42) arranged to derive two further phase-quadrature outputs from said reference signal, gating means (43) connected to the outputs of said two further mixers (40, 41), an additional mixer circuit (46) connected to the output of one of said first mixers and one of said further phase-quadrature signals, and a loop integrator amplifier (33) having one input connected to the output of said additional mixer circuit (46) and a second input derived from the output of said gating means (43).

5. A circuit as claimed in Claim 4 characterised by a sweep circuit (47) operable to cause the frequency of the voltage-controlled oscillator (10) to sweep over its tuning range, the said sweep circuit (47) being connected to the second input of the loop integrator amplifier (33) and controlled by the output of said gating means (43).

# FIG.1

# FIG.2

5

# FIG.3

# FIG.4

## FIG.5